Europäisches Patentamt

European Patent Office

Office européen des brevets

(19)

(11) Publication number: **0 209 194 B1**

(12) **EUROPEAN PATENT SPECIFICATION**

(45) Date of publication of patent specification: **17.04.91** (51) Int. Cl.5: **H01L 21/306**

(21) Application number: **86201220.0**

(22) Date of filing: **14.07.86**

(54) Method of manufacturing a semiconductor device, in which a layer of gallium arsenide is etched in a basic solution of hydrogen peroxide.

(30) Priority: **15.07.85 NL 8502022**

(43) Date of publication of application:
**21.01.87 Bulletin 87/04**

(45) Publication of the grant of the patent:
**17.04.91 Bulletin 91/16**

(84) Designated Contracting States:
**DE FR GB NL**

(56) References cited:
**EP-A- 0 137 573**
**FR-A- 2 168 936**
**FR-A- 2 200 374**
**FR-A- 2 486 104**

**JOURNAL OF THE ELECTROCHEMICAL SOCIETY, vol. 130, no. 12, 12th December 1983, pages 2427-2435, Manchester, US; S. ADACHI et al.: "Chemical etching characteristics of (001) GaAs"**

(73) Proprietor: **N.V. Philips' Gloeilampenfabrieken Groenewoudseweg 1 NL-5621 BA Eindhoven(NL)**

(72) Inventor: **Dinghs, Gerardus Lambertus c/o INT. OCTROOIBUREAU B.V. Prof. Holstlaan 6 NL-5656 AA Eindhoven(NL)**
Inventor: **Rheiter, Hendrikus Johannes Hubertus c/o INT. OCTROOIBUREAU B.V. Prof. Holstlaan 6 NL-5656 AA Eindhoven(NL)**
Inventor: **Tijburg, Rudolf Paulus c/o INT. OCTROOIBUREAU B.V. Prof. Holstlaan 6 NL-5656 AA Eindhoven(NL)**

(74) Representative: **Rensen, Jan Geert et al Internationaal Octrooibureau B.V. Prof. Holstlaan 6 NL-5656 AA Eindhoven(NL)**

JOURNAL OF THE ELECTROCHEMICAL SOCIETY, vol. 129, no. 10, October 1982, pages 2380-2382, Manchester, US; K. KENEFICK: "Selective etching characteristics of peroxide/ammonium-hydroxide solutions for GaAs/Al0.16Ga0.84As"

JOURNAL OF THE ELECTROCHEMICAL SOCIETY, vol. 121, no. 9, September 1974, pages 1215-1219, Manchester, US; J.J. GANNON et al.: "A chemical etchant for the selective removal of GaAs through SiO2 masks"

## Description

The invention relates to a method of manufacturing a semiconductor device, in which a photolacquer mask is provided on a (001) or equivalently orientated surface of a monocrystalline layer of gallium arsenide, after which the layer is etched in a basic solution of hydrogen peroxide. The term "(001) or equivalently orientated surface" is to be understood herein to mean a surface which extends parallel to one of the crystal surfaces (001), (010) and (100) of the monocrystalline layer of gallium arsenide.

As appears, for example, from J. Appln. Phys., Vol. 44, No. 9, September 1973, pages 4172-4176, with a basic solution (with pH> 6) of hydrogen peroxide an epitaxial layer of gallium arsenide can be etched with a high selectivity with respect to a layer of gallium aluminium arsenide. Such a high etching selectivity is very desirable, for example, in the manufacture of semiconductor lasers or laser diodes.

From J. Electrochem. Soc., "Solid-State Science and Technology", Vol. 130, No. 12, December 1983, pages 2427-2435, a method of the kind mentioned in the opening paragraph is known, in which use is made of strong basic solutions having a pH> 9. The acidity of the etching solution is determined here by the addition of sodium or potassium hydroxide or ammonia. The process of etching the (001)-orientated layer of gallium arsenide is effected preferentially, which means that, when a groove is etched, which extends parallel to the [110] direction, a groove having a dovetail profile is obtained and, when a groove is etched which extends parallel to the [$\bar{1}$ 10] direction, a groove having a V-shaped profile is obtained.

Such a preferential etching behaviour of an etching solution means that the method mentioned in the opening paragraph is suitable only for the manufacture of a very limited number of semiconductor devices.

The invention has inter alia for its object to considerably enlarge the usability of the method by enlarging the usability of the etching solution.

According to the invention, the method of the kind mentioned in the opening paragraph is for this purpose characterized in that the layer is etched in a solution having an acidity which is determined in such a manner that, when a groove extending parallel to a [110] or equivalent direction is etched in the layer, this groove has a V-shaped cross-section. The term "a [110] or equivalent direction" is to be understood herein to mean the [110] direction when the groove is etched in a (001)-orientated surface, the [011] direction when this is the case in a (100)-orientated surface and the [101] direction when this is the case in a (010)-orientated surface, that is to say in each of the possible orientations of the layer of gallium arsenide that direction which corresponds to the [110] direction with a layer having a (001)-orientated surface. A V-shaped groove is to be understood to mean a groove which tapers in do wnward direction, in contrast with a dovetail-shaped groove, which widens in downward direction.

Due to the choice of the acidity in accordance with the invention, it is achieved that a groove having a V-shaped cross-section can be etched in a direction which is transverse to that in which a groove having a V-shaped cross-section is obtained with the known strong basic etching solution. In this case, the V-shaped groove extended in the [$\bar{1}$ 10] direction. In the [$\bar{1}$ 10] direction, a dovetail-shaped groove can be obtained by means of the method according to the invention.

It has surprisingly been found that by a suitable choice of the acidity of the solution of hydrogen perioxide, the usability of the method mentioned in the opening paragraph is considerably enlarged.

A preferred embodiment of the method according to the invention is characterized in that the acidity of the solution is determined in such a manner that, when at the same time a groove extending parallel to a [$\bar{1}$ 10] or equivalent direction is etched in the layer, this groove also has a V-shaped cross-section. Thus, the usability of the method of the kind mentioned in the opening paragraph is even further enlarged.

The fact that a V-shaped groove can be etched in the [110] direction is of great importance in the manufacture of semiconductor lasers, while the fact that a V-shaped groove can be etched simultaneously both in the [110] and in the [$\bar{1}$ 10] direction is of great importance in the manufacture of integrated circuits, in which mutually insulated islands of gallium arsenide are present.

The invention will now be described more fully, by way of example, with reference to a drawing and a few embodiments. In the drawing:

Figures 1 and 2 show diagrammatically and in cross-section a few stages of the manufacture of a semi-conductor laser obtained by means of the method according to the invention, and

Figures 3 and 4 show shapes of grooves obtained during etching of a (001)-orientated layer of gallium arsenide in the [110] and the [$\bar{1}$ 10] direction, respectively.

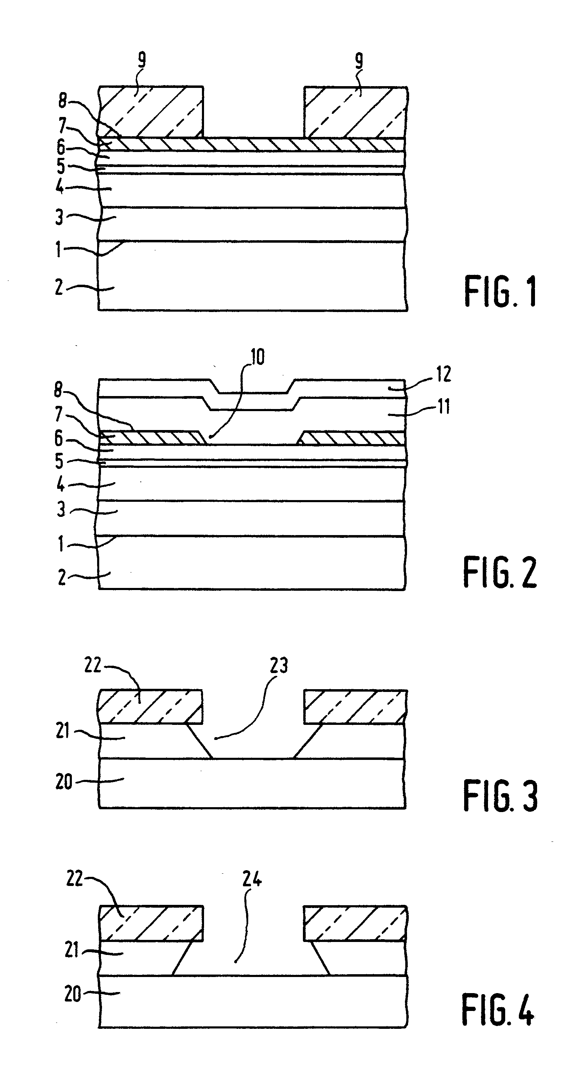

Figures 1 and 2 show diagrammatically and in cross-section a few stages of the manufacture of a semi-conductor laser obtained by means of the method according to the invention. In a usual manner, an about 2 $\mu$m thick n -type layer of gallium arsenide 3 having a doping concentration of about $10^{18}$ atoms/cm$^3$, an about 2 $\mu$m thick layer of gallium aluminium arsenide 4 having a composition Ga$_{0.65}$Al$_{0.35}$ As and a doping concentration of about $10^{18}$ atoms/cm$^3$, an about 0.1 $\mu$m thick so-called active undoped layer of gallium arsenide 5, an about 0.4 $\mu$m thick $\underline{p}$ -type of gallium aluminium arsenide 6 having a composition Ga$_{0.65}$Al$_{0.35}$As and a doping concentration of about $5.10^{17}$ atoms/cm$^3$ and an about 0.5$\mu$m thick n -type layer of gallium arsenide 7 having a doping concentration of about $3.10^{18}$ atoms/cm$^3$ are successively formed by means of liquid phase epitaxy (LPE) on a (001)-orientated surface 1 of an n -type gallium arsenide substrate 2, that is to say on a surface 1 extending parallel to (001) crystal surfaces of the gallium arsenide substrate 2. Thus, the layer of gallium arsenide 7 has a surface 8 which also extends parallel to (001) crystal surfaces; consequently, this surface 8 is also (001)-orientated. In this embodiment, the starting material was a (001)-orientated substrate 2 with a (001)-orientated layer 7 of gallium arsenide, but a similar situation had been possible by starting from a (010)-or a (100)-orientated substrate and gallium arsenide layer.

A photolacquer mask 9 is provided on the (001)-orientated surface 8 of the monocrystalline layer 7 of gallium arsenide, after which the layer is etched in a basic solution of hydrogen peroxide. By means of such a solution, the layer 7 of gallium arsenide can be etched with a high selectivity with respect to the layer 6 of gallium aluminium arsenide. By the etching treatment, an about 5 $\mu$m wide groove 10 directed at right angles to the plane of the drawing is etched into the layer 7 of gallium arsenide. The layer 6 of gallium aluminium arsenide is then practically not attacked.

According to the invention, the layer 7 of gallium arsenide is etched in a solution having an acidity (pH) which is determined so that, when a groove extending parallel to a [110] or equivalent direction is etched into the layer 7 of gallium arsenide, this groove has a V-shaped cross-section. The term "a [110] or equivalent direction" has to be understood to mean that for a (001)-orientated surface 8 the [110] direction is meant and for a (100) - and a (010)-orientated surface 8 the [011]and the [101] direction, respectively, are meant. In the embodiment, the groove 10 extends in the [110] direction and the groove 10 has a V-shaped cross-section. The term "V-shaped cross-section" is to be understood to mean a cross-section which tapers in downward direction.

After the groove 10 has been etched into the layer 7 of gallium arsenide, the photolacquer mask 9 is removed and an about 2 $\mu$m thick $\underline{p}$ -type layer 11 of gallium aluminium arsenide having a doping concentration of about $5.10^{17}$ atoms/cm$^3$ and an about 0.2$\mu$m thick $\underline{p}$ -type gallium arsenide contact layer 12 are formed successively in a usual manner by means of an epitaxial growing process from a gas mixture of metal-organic gases (MOCVD).

After mirror surfaces extending at right angles to the [110] direction have been formed, for example by cleaving the assembly of the substrate 2 with the layers 3, 4, 5, 6, 7, 11, 12 provided thereon, the layer 12 and the substrate 2 are finally provided with electrical connections (not shown). The groove 10 defines the area at which the current flows through the laser and at which consequently the laser light is generated in the active layer 5.

Figures 3 and 4 show a layer 20 of gallium aluminium arsenide, on which a monocrystalline layer 21 of gallium arsenide is formed, which is covered with a photolacquer mask 22. The layer 21 of galliumarsenide is (001)-orientated; in Fig. 3, the [110] direction extends at right angles to the plane of the drawing, while in Fig. 4 the [$\bar{1}$ 10] direction extends at right angles to this plane. By the etching treatment according to the invention, a groove 23 having a V-shaped cross-section is etched in the [110] direction and a groove 24 having a dovetail-shaped cross-section is etched in the [$\bar{1}$ 10] direction; that is to say that the width of this groove decreases (23) and increases (24), respectively, in downward direction. As will still appear, the acidity has to be comparatively low (pH<8.2). When the acidity is adjusted so as to be comparatively high (pH>9), quite different grooves are obtained; the groove extending in the [110] direction then has a dovetail-shaped cross-section, while the groove extending in the [$\bar{1}$ 10] direction has a V-shaped cross-section.

The V-shaped groove, which is etched with a strong basic solution (pH>9), has flat surfaces constituted by ($\bar{1}\bar{1}$ 1) surfaces, which are occupied by gallium atoms; the V-shaped groove, which is etched with a comparatively weak basic solution (pH<8.2), has slightly curved walls, which contain a comparatively large number of arsenic atoms. This is of great importance if by means of a growing process from a gas mixture of metal-organic constituents (MOCVD) a layer has to be provided. Deposition on a surface containing a comparatively large number of arsenic atoms is effected in a much simpler manner than on a surface containing only gallium atoms. This is due to the fact that gallium oxides are much more stable than arsenic oxides and are broken down only slowly during the deposition process, which is effected at a comparatively low temperature, while arsenic oxides then evaporate.

In a preferred embodiment of the method according to the invention, the acidity of the solution is determined so that, when a groove is etched in the [$\bar{1}$ 10] direction into the layer 7,21 of galliumarsenide, this groove, like a groove in the [110] direction, has a V-shaped cross-section. The acidity then lies in the range of from 7.80 to 8.25. This favourable property renders the method particularly suitable for the manufacture of integrated circuits, in which mutually insulated islands of gallium arsenide are present. The V-shaped grooves can be much more readily filled with an insulating material than grooves having a dovetail-shaped cross-section.

In the following examples, a (001)-orientated undoped layer of gallium arsenide was etched at room temperature in a 30% solution of hydrogen peroxide. Different substances were added to this solution inter alia for determining the acidity. The gallium arsenide layer was provided with a photolacquer mask, which was provided with slot-shaped openings so that it was possible to etch grooves into the gallium arsenide layer both in the [110] direction and in the [$\bar{1}$ 10] direction.

Example 1.

The pH of the 30% solution of hydrogen peroxide was adjusted by means of the addition of a 10% solution of sodium hydroxide. Table I indicates for both directions in which a groove was etched, what was the shape of the etched grooves in dependence upon the pH of the etching solution.

Table 1

|  | direction of the groove | |
|---|---|---|
| pH | [110] | [$\bar{1}$10] |
| 7.00 | V | Z |
| 7.25 | V | Z |
| 7.50 | V | Z |
| 7.60 | V | Z |
| 7.70 | V | Z |
| 7.80 | V | V |
| 7.90 | V | V |
| 8.00 | V | V |
| 8.25 | V | V |
| 8.50 | Z | V |
| 8.75 | Z | V |
| 9.00 | Z | V |

In the Table, a V-shaped groove is designated by V and a dovetail-shaped groove is designated by Z. When etching in a solution having a pH less than 8.25, a V-shaped groove is obtained in the [110] direction and when etching in a solution having a pH of 7.80 to 8.25, a V-shaped groove is obtained both in the [110] direction and in the [$\bar{1}$ 10] direction.

Example II.

The pH of the 30% solution of hydrogen peroxide was adjusted by means of the addition of a 25% solution of ammonia. The etching results were identical to those in Example I.

It should be noted that the shape of the etched groove does not change abruptly in the embodiment described above from the V-form to the dovetail form. The mixed forms having a V-shaped character are designated in the tables by V and the mixed forms having a dovetail character are designated therein by Z.

The acidity of the etching solution may be determined by other bases, such as, for example, potassium hydroxide. In all these cases, corresponding results are obtained. A weak acid may also be added to the etching solution, after which the acidity is adjusted by a base. If, for example, perchloric acid is added as acid and if then the acidity is adjusted by means of ammonia, the etching process is effected more rapidly than in a solution having the same acidity, to which only ammonia is added.

## Claims

1. A method of manufacturing a semiconductor device, in which a photolacquer mask is respectively provided on a (001), (100) or (010) orientated surface of a monocrystalline layer of gallium arsenide and patterned with openings running parallel to the [110], [011] or [101] directions respectively, after which the said layer is etched in a basic solution of hydrogen peroxide, characterized in that the solution acidity (pH) is lower than 8,25 so that grooves extending parallel to the [110], [011] or [101] direction, respectively, are etched into the said layer having a V-shaped cross section.

2. A method as claimed in Claim 1, characterized in that the acidity (pH) of the said solution is 7,8 to 8,25, so that, on also etching a groove which extends parallel to a [$\bar{1}$ 10], [0$\bar{1}$ 1] or [$\bar{1}$ 01] direction, respectively, into the said layer this groove has also a V-shaped cross section.

## Revendications

1. Procédé de fabrication d'un dispositif semiconducteur dans lequel un photomasque en vernis est respectivement prévu sur une face orientée suivant (001) , (100) ou (010) d'une couche monocristalline d'arséniure de gallium et est pourvu d'ouvertures s'étendant parallèlement aux directions [110], [011] ou [101] respectivement, après quoi ladite couche est soumise à une morsure dans une solution alcaline de peroxyde d'hydrogène, caractérisé en ce que l'acidité de la solution (pH) est inférieure à 8,25, de sorte que des rainures s'étendant parallèlement à la direction [100], [011] ou [101] respectivement sont formées dans la couche avec une section transversale en V.

2. Procédé suivant la revendication 1, caractérisé en ce que l'acidité (pH) de la solution est de 7,8 à 8,25, de sorte que, lors de la formation par morsure, dans ladite couche, d'une rainure qui s'étend parallèlement à une direction [$\bar{1}$ 10], [0$\bar{1}$ 1] ou [$\bar{1}$ 01] respectivement, cette rainure a également une section transversale en V.

## Ansprüche

1. Verfahren zum Herstellen einer Halbleiteranordnung, wobei auf einer (001), (100) oder (010) orientierten oberfläche einer monokristallinen Schicht aus Galliumarsenid eine Photolackmaske angebracht wird, die mit einem Offnungenmuster versehen wird, dessen Offnungen die sich parallel zu der bertreffenden Richtung [110], [011] bzw. [101] erstrecken, wonach die genannte Schicht in einer Basislsung von Wasserstoffperoxid geätzt wird, dadurch gekennzeichnet, daß der Säuregehalt (pH) der Lösung niedriger ist als 8,25, so daß Rillen, die sich parallel zu der [110], [011] oder [101]-Richtung erstrecken, in der genannten Schicht geätzt werden und einen V-förmigen Querschnitt aufweisen.

2. Verfahren nach Anspruch 1, dadurch gekennzeichnet, daß der Säuregehalt (pH) der genannten Lösung 7,8 bis 8,25 beträgt, so daß, wenn ebenfalls eine Rille, die sich parallel zu einer [$\bar{1}$ 10], [0$\bar{1}$ 1] oder [$\bar{1}$ 01]-Richtung erstreckt, in die genannte Schicht geätzt wird, diese Rille ebenfalls einen V-förmigen Querschnitt aufweist.

FIG. 1

FIG. 2

FIG. 3

FIG. 4